# EUROPEAN PATENT APPLICATION

(11) **EP 3 554 058 A1**
(43) Date of publication of application: **16.10.2019**
(21) Application number: 18215838.6
(22) Date of filing: 24.12.2018
(51) Int. Cl.: H04M 1/18, H04M 1/21, H04M 1/02

(54) **MOBILE PHONE HOUSING WITH A LEATHER CARD HOLDER**

(30) Priority: 10.04.2018 TW 10704636 U
(71) Applicant: Pegatron Corporation, Taipei City (TW)
(72) Inventor: CHUNG, Chih-Cheng, Taipei (TW); CHEN, Hsiao-Cheng, Taipei (TW); LEE, Cheng-Yi, Taipei (TW)
(74) Representative: Viering, Jentschura & Partner mbB Patent- und Rechtsanwälte

(57) **Abstract**

The present invention relates to a mobile phone housing (10, 10a), which may be configured to contain a mobile phone (20). The mobile phone housing (10, 10a) includes a plastic body (100) and a leather interlayer (200). The plastic body (100) includes a mobile phone accommodating portion (102) configured to contain the mobile phone (20), an outer surface (104) and a retaining wall (110, 110a). The outer surface (104) is disposed on an opposite side of the mobile phone accommodating portion (102), and the retaining wall (110, 110a) is located on the outer surface (104). The leather interlayer (200) includes a card insertion portion (202). The leather interlayer (200) is attached to the outer surface (104), and the retaining wall (110, 110a) surrounds the leather interlayer (200). By means of the structural design of the present invention, the manpower and time required for production can be reduced, and the yield can be increased, thereby reducing the production costs. In addition, the retaining wall (110, 110a) can protect an edge (204) of the leather interlayer (200) from being worn easily.

## Description

### BACKGROUND

### Technical Field

The present invention relates to a mobile phone housing, and in particular, to a mobile phone housing which can accommodate a card.

### Related Art

Current smart phones are lightweight, versatile and expensive. In order to protect a smart phone, and to reduce a chance of being damaged when the smart phone is hit or accidentally dropped, a user often adds a mobile phone housing to the smart phone. Existing mobile phone housings may be classified into many styles. One style is a two-piece clamshell mobile phone housing. A smart phone can be fixed on an inner side of one of the two pieces, and the other piece can cover a screen of the mobile phone. Another style is a single-piece fixed mobile phone housing which can cover sides and a back surface of a smart phone, but expose a screen of the mobile phone. Based on use convenience, the single-piece fixed mobile phone housing is a mainstream style at present.

Since smart phones are one of things that people most often hold, and credit cards or e-tickets (such as an EasyCard) is also frequently used when people are outside, there exists a single-piece fixed mobile phone housing whose back surface is disposed with a card interlayer. A user can insert the credit cards or e-tickets into the card interlayer. Since these cards and the mobile phone are put together, it is convenient for the user to take the cards. The existing single-piece fixed mobile phone housing having a card interlayer is usually made by fully covering the mobile phone housing with leather and forming the card interlayer on the leather.

### SUMMARY

The existing single-piece fixed mobile phone housing having a card interlayer is made by fully covering the mobile phone housing with leather and forming the card interlayer on the leather. In this case, it is necessary to manually cover a mobile phone housing having a plurality of faces and a plurality of angles with leather by using specially designed jigs, which consumes a large amount of manpower and production time, and causes an unstable yield. Therefore, production costs remain high. Moreover, after the existing mobile phone housing has been used for a long time, an edge and a corner of the leather are prone to burrs or cracks due to frequent frictions.

In view of this, an objective of the present invention is to propose a mobile phone housing, to reduce the manpower and time required for production, improve the yield and reduce the production costs by using a structural design. Moreover, burrs or cracks caused by frequent frictions on the edge and corner of the leather can further be prevented.

A mobile phone housing according to an embodiment of the present invention can be configured to contain a mobile phone. The mobile phone housing includes a plastic body and a leather interlayer. The plastic body includes a mobile phone accommodating portion configured to contain the mobile phone, an outer surface and a retaining wall. The outer surface is disposed on an opposite side of the mobile phone accommodating portion, and the retaining wall is located on the outer surface. The leather interlayer includes a card insertion portion. The leather interlayer is attached to the outer surface, and the retaining wall surrounds the leather interlayer.

In summary, the mobile phone housing according to the embodiment of the present invention reduces the manpower and time required for production and improves the yield, thereby reducing the production costs. Moreover, by means of a design of the retaining wall, an edge of the leather interlayer can further be protected from being worn easily. In this way, the problem is also resolved that the edge and the corner of the leather are prone to burrs or cracks due to frequent frictions after the conventional mobile phone housing has been used for a long time.

Detailed features and advantages of the present invention are described in detail in the following implementations, of which the content is sufficient to enable those skilled in the art to understand and implement the technical content of the present invention. Moreover, those skilled in the art can easily understand the objective and advantages related to the present invention according to the disclosed content of this specification, claims and the drawings.

### BRIEF DESCRIPTION OF THE DRAWINGS

FIG. 1 is a schematic diagram of a mobile phone housing according to an embodiment of the present invention;
FIG. 2 is an exploded view of a mobile phone housing according to an embodiment of the present invention;
FIG. 3 is a cross-sectional view of the mobile phone housing in FIG. 1 along a line segment 3-3;
FIG. 4 is a cross-sectional view of the mobile phone housing in FIG. 3 when a card is inserted;
FIG. 5 is a schematic diagram of a mobile phone housing according to another embodiment of the present invention; and
FIG. 6 is a cross-sectional view of the mobile phone housing in FIG. 5.

### DETAILED DESCRIPTION

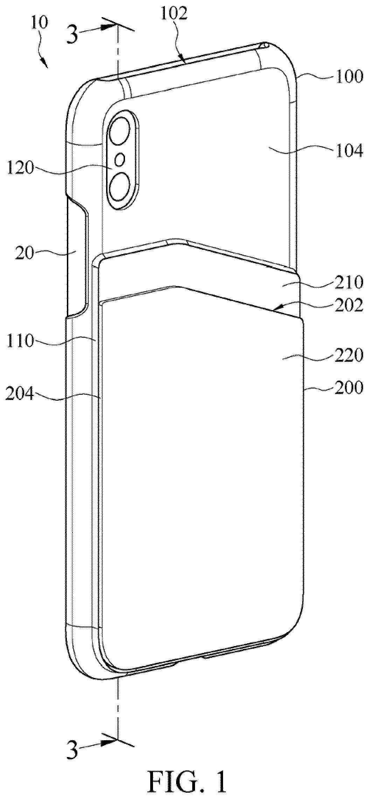

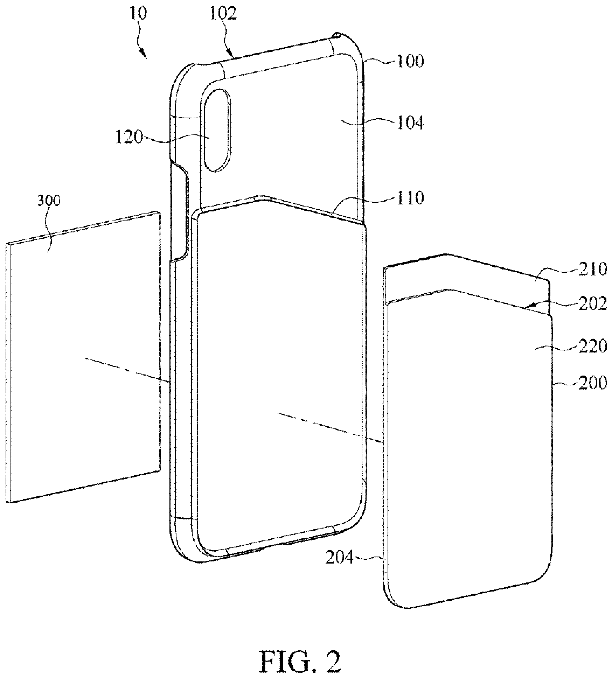

FIG. 1 is a schematic diagram of a mobile phone housing 10 according to an embodiment of the present invention, and FIG. 2 is an exploded view of the mobile phone housing 10 according to this embodiment of the present invention. As shown in FIG. 1, in this embodiment, the mobile phone housing 10 is sleeved on a smart phone 20, but is not limited thereto. For example, the mobile phone housing 10 is of a single-piece fixed style, and can cover sides and a back surface of the smart phone 20, but expose a screen of the mobile phone 20. In other embodiments, the mobile phone housing 10 is also applicable to a two-piece clamshell style.

As shown in FIG. 1 and FIG. 2, the mobile phone housing 10 includes a plastic body 100 and a leather interlayer 200. The plastic body 100 includes a mobile phone accommodating portion 102 configured to contain the mobile phone 20, an outer surface 104 and a retaining wall 110. The outer surface 104 is disposed on an opposite side of the mobile phone accommodating portion 102. Sides and a back surface of the mobile phone 20 come into contact with the mobile phone accommodating portion 102 of the mobile phone housing 10, and the retaining wall 110 is located on the outer surface 104. The leather interlayer 200 includes a card insertion portion 202, and the leather interlayer 200 is attached to the outer surface 104. The retaining wall 110 surrounds the leather interlayer 200, and the retaining wall 110 may be configured to protect an edge 204 of the leather interlayer 200. The card insertion portion 202 may enable a user to insert a card such as a credit card or an e-ticket. The user can hold and use the mobile phone 20 installed with the mobile phone housing 10, and can conveniently take the card from the leather interlayer 200 when needed.

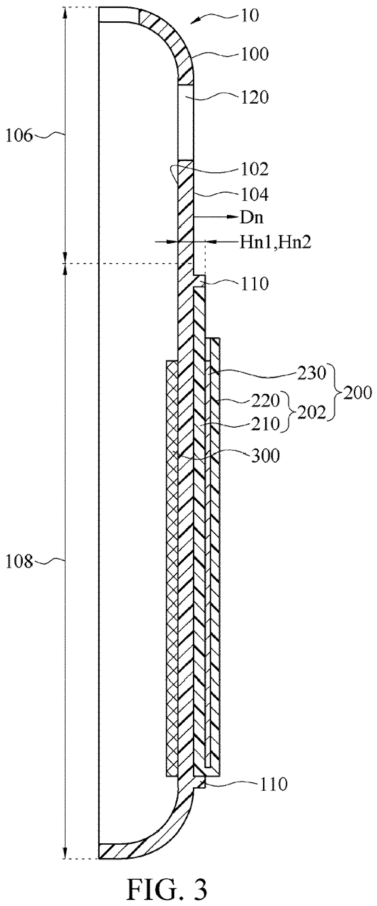

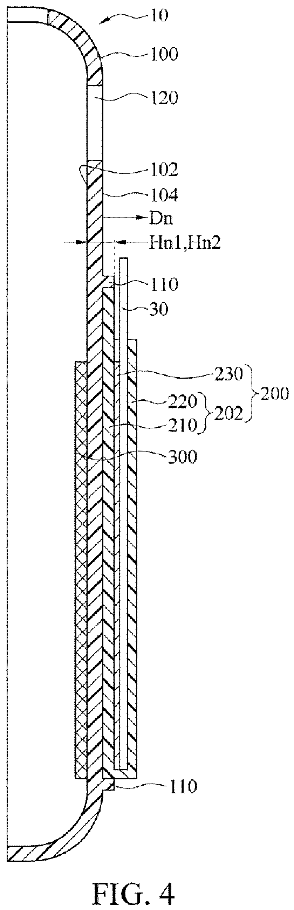

FIG. 3 is a cross-sectional view of the mobile phone housing 10 in FIG. 1 along a line segment 3-3, and FIG. 4 is a cross-sectional view of the mobile phone housing 10 in FIG. 3 when a card 30 is inserted. As shown in FIG. 1 to FIG. 4, in this embodiment, the retaining wall 110 protrudes from the outer surface 104 of the plastic body 100, and the retaining wall 110 protrudes from the outer surface 104 to form an annular protrusion portion, and the leather interlayer 200 matches the annular protrusion portion. Moreover, the retaining wall 110 and the plastic body 100 may be integrated into one body. For example, the retaining wall 110 and the plastic body 100 can be integrally formed by using an injection molding process, but are not limited thereto.

As shown in FIG. 1 to FIG. 4, in this embodiment, the leather interlayer 200 may further include a first layer 210 and a second layer 220. The first layer 210 is attached to the outer surface 104, the second layer 220 is attached to the first layer 210 and exposes a part of the first layer 210, and the first layer 210 and the second layer 220 form the card insertion portion 202. For example, the first layer 210 may be attached to the outer surface 104 through gluing and the retaining wall 110 surrounds the first layer 210. Through sewing or gluing, the first layer 210 may be connected to three edges of the second layer 220, while an edge of the second layer 220 that is not connected to the first layer 210 serves as an opening of the card insertion portion 202. As shown in FIG. 3, an edge located in an upper part in FIG. 3 of the card insertion portion 202 is the opening of the card insertion portion 202. As shown in FIG. 4, the card 30 may be inserted into the card insertion portion 202 through the opening. It should be understood that, in practical applications, since the leather interlayer 200 is elastic, in a case where the card insertion portion 202 is vacant, the first layer 210 and the second layer 220 may come into contact with each other without gaps. However, after the card 30 is inserted, the second layer 220 is stretched due to an elastic deformation, and may generate an elastic restoring force to press the card 30 to be fixed in the card insertion portion 202.

As shown in FIG. 3 and FIG. 4, in this embodiment, in a normal direction Dn of the outer surface 104 of the plastic body 100, the leather interlayer 200 has a height relative to the outer surface 104 of the plastic body 100. Therefore, in the absence of the retaining wall 110, whether the user fetches or puts the smart phone 20 provided with the mobile phone housing 10 from or into a pocket or a bag, or the user holds the smart phone 20 to operate or take the card 30 from the card insertion portion 202, the edge 204 of the leather interlayer 200 is easily rubbed by an external object, such as the user's hand, the pocket or the bag. Over time, the edge 204 of the leather interlayer 200 is damaged by frictions, resulting in burrs or cracks.

Based on a structural design of the mobile phone housing 10 in this embodiment, the retaining wall 110 may resolve the above problems. Since the edge 204 of the first layer 210 is a portion most easily damaged by frictions during use of the mobile phone housing 10, a height of the retaining wall 110 may be set to be equal to or greater than a height of the first layer 210, to protect the edge 204 of the first layer 210. As shown in FIG. 3, in this embodiment, the first layer 210 has a height Hn1 in the normal direction Dn relative to the outer surface 104, and the retaining wall 110 has a height Hn2 in the normal direction Dn relative to the outer surface 104. The height Hn1 of the first layer 210 and the height Hn2 of the retaining wall 110 are approximately equal, but are not limited thereto.

As shown in FIG. 1 to FIG. 4, in this embodiment, the retaining wall 110 is adjacent to the edge 204 of the leather interlayer 200. For example, an annular contour formed by the retaining wall 110 matches the edge 204 of the first layer 210 of the leather interlayer 200, and the retaining wall 110 and the edge 204 of the first layer 210 come into close contact with each other. In this way, in addition to allowing the retaining wall 110 to better protect the edge 204 of the first layer 210, this structure has a better aesthetic appearance and can prevent dust or foreign matters from getting stuck between the retaining wall 110 and the leather interlayer 200.

As shown in FIG. 3 and FIG. 4, in this embodiment, the leather interlayer 200 may further include a magnetic isolation layer 230. The magnetic isolation layer 230 is located in the card insertion portion 202. The magnetic isolation layer 230 may be configured to isolate magnetic lines or magnetic fields between the mobile phone 20 and the card 30, so as to avoid electromagnetic interference between the mobile phone 20 and the card 30. For example, when the card 30 in the card insertion portion 202 belongs to an inductive credit card or e-ticket (such as an EasyCard), and the user needs to sense the card 30 by directly putting the mobile phone housing 10 close to a sensing device without pulling out the card 30 from the card insertion portion 202, the magnetic isolation layer 230 can prevent an electrical element of the mobile phone 20 from affecting sensing of the card 30. In different embodiments, the magnetic isolation layer 230 may be a separable element disposed in the card insertion portion 202, that is, the magnetic isolation layer 230 may be pulled out from and inserted into the leather interlayer 200. Alternatively, the magnetic isolation layer 230 may be attached to one side of the card 30, so that when the card 30 is inserted into the card insertion portion 202, the magnetic isolation layer 230 is located between the card 30 and the first layer 210. In this embodiment, a magnetic isolation piece may include a PET (polyethylene terephthalate) layer and a graphene layer that are laminated, but is not limited thereto.

As shown in FIG. 1 to FIG. 4, in this embodiment, the plastic body 100 may further include a camera hole 120. The camera hole 120 connects the mobile phone accommodating portion 102 and the outer surface 104, and is disposed corresponding to a camera lens of the mobile phone 20. Moreover, the leather interlayer 200 does not overlap the camera hole 120 in the normal direction Dn of the outer surface 104. For example, as shown in FIG. 3, the mobile phone housing 10 may be divided into a first part 106 and a second part 108 as a whole. In this embodiment, the first part 106 of the mobile phone housing 10 is a part located on an upper side, and the camera hole 120 passes through the first part 106. The second part 108 is a part located on a lower side, and the second part 108 does not have a hole. The retaining wall 110 and the leather interlayer 200 are disposed on the outer surface 104 of the second part 108. Therefore, the leather interlayer 200 in the normal direction Dn of the outer surface 104 does not overlap the first part 106. In addition, the leather interlayer 200 also does not overlap the camera hole 120. In other words, the leather interlayer 200 does not obscure the camera lens of the mobile phone 20. Therefore, in the production of the mobile phone housing 10, only the camera hole 120 needs to be provided on the plastic body 100, with no need to provide extra holes in the leather interlayer 200 to correspond to the camera lens of the mobile phone 20, so that it is easier and more convenient to produce the mobile phone housing 10.

As shown in FIG. 2 to FIG. 4, in this embodiment, the mobile phone housing 10 further includes a pad body 300. The pad body 300 is located in the mobile phone accommodating portion 102. When the mobile phone housing 10 is appropriately installed on the mobile phone 20, the pad body 300 is located between the back surface of the mobile phone 20 and the mobile phone accommodating portion 102 of the mobile phone housing 10. Regardless of the mobile phone 20 or the mobile phone housing 10, there may be a slight tolerance in production. Therefore, after the mobile phone housing 10 is installed on the mobile phone 20, there may be a gap between the mobile phone 20 and the mobile phone housing 10 due to the tolerance, but the pad body 300 may fill the gap between the mobile phone 20 and the mobile phone housing 10, making the mobile phone housing 10 more firmly fixed on the mobile phone 20. In this embodiment, the pad body 300 may be a thin cloth pad, such as microfiber cloth, but is not limited thereto.

In this embodiment, the plastic body 100 and the leather interlayer 200 are of a heterostructure. The heterostructure can be used for different purposes. For example, the plastic body 100 may be produced by adopting a plastic high polymer, but is not limited thereto. The leather interlayer 200 may be produced by adopting leather, but is not limited thereto.

In this embodiment, the leather interlayer 200 may be attached to the outer surface 104 through gluing. Based on the structural design of the mobile phone housing 10 in this embodiment, the production method of the leather interlayer 200 is different from the conventional method in which the housing having a plurality of faces and a plurality of angles needs to be manually fully covered with the leather. Instead, the leather interlayer 200 and the plastic body 100 of the mobile phone housing 10 in this embodiment only need to be joined through a single surface (that is, joining an outer side face of the first layer 210 to the outer surface 104 surrounded by the retaining wall 110), so as to complete the assembly. Therefore, based on the structural design of the mobile phone housing 10 in this embodiment, the separately prepared leather interlayer 200 and plastic body 100 may be abutted by using an automatic production machine, thereby greatly improving the production efficiency. Moreover, even if the leather interlayer 200 and the plastic body 100 are produced manually, the production can also be completed simply and quickly. For example, the retaining wall 110 may serve as a good abutting tool. The producer only needs to apply an adhesive material to the outer surface 104 surrounded by the retaining wall 110 or the outer side face of the first layer 210, align the leather interlayer 200 with the outer surface 104 surrounded by the retaining wall 110, and put the leather interlayer 200 along the retaining wall 110, to accurately complete the production. Such a structural design helps reduce the manpower and time required for the production, improve the yield, and lower the production costs.

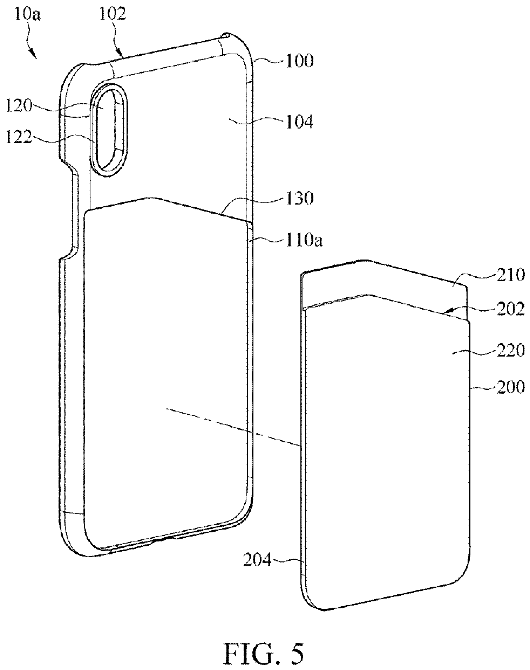

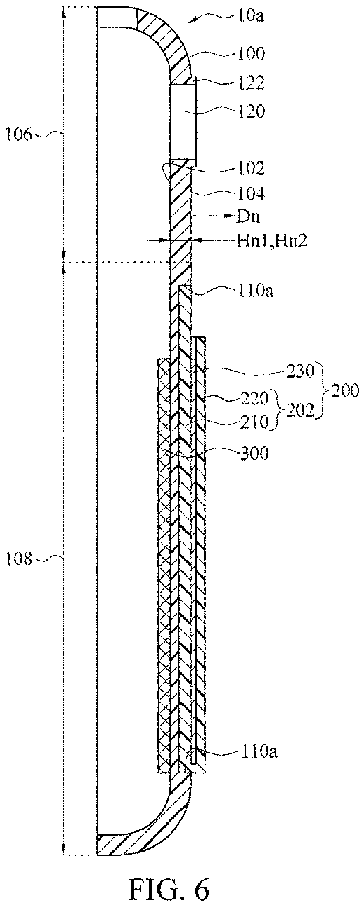

FIG. 5 is a schematic diagram of a mobile phone housing 10a according to another embodiment of the present invention, and FIG. 6 is a cross-sectional view of the mobile phone housing 10a in FIG. 5. For the mobile phone housing 10a shown in FIG. 5 and FIG. 6, refer to an illustration of the mobile phone housing 10 shown in FIG. 1 to FIG. 4. As shown in FIG. 5 and FIG. 6, in this embodiment, the mobile phone housing 10a includes a plastic body 100a and a leather interlayer 200. The plastic body 100a includes a mobile phone accommodating portion 102 configured to contain a mobile phone 20, an outer surface 104 and a retaining wall 110a. The outer surface 104 is disposed on an opposite side of the mobile phone accommodating portion 102, and the retaining wall 110a is located on the outer surface 104. In this embodiment, the retaining wall 110a is recessed in the outer surface 104 to form a recessed portion 130, and the leather interlayer 200 matches the recessed portion 130 and is disposed in the recessed portion 130.

As shown in FIG. 5 and FIG. 6, in this embodiment, the recessed portion 130 is a stepped structure formed by the outer surface 104 of the plastic body 100a being recessed in the normal direction Dn. The retaining wall 110a is an annular side wall formed due to a step around the recessed portion 130. The leather interlayer 200 is attached to the recessed portion 130, and the annular side wall formed by the retaining wall 110a surrounds the leather interlayer 200. In this embodiment, since the plastic body 100a has a thin thickness in the recessed portion 130 (relative to the remaining non-recessed portion of the plastic body 100a), the overall mechanical strength may be reduced. Therefore, the thickness of the plastic body 100a in the normal direction Dn may further be thickened (relative to the plastic body 100a shown in FIG.1 to FIG. 4) to improve the overall mechanical strength, but is not limited thereto.

As shown in FIG. 5 and FIG. 6, in this embodiment, the leather interlayer 200 includes a card insertion portion 202, a first layer 210, a second layer 220 and a magnetic isolation layer 230. The first layer 210 of the leather interlayer 200 is attached to the outer surface 104 of the recessed portion 130. In addition, the second layer 220 is attached to the first layer 210. The first layer 210 and the second layer 220 form the card insertion portion 202. The magnetic isolation layer 230 is located in the card insertion portion 202, the retaining wall 110a surrounds the first layer 210, and the retaining wall 110a may be configured to protect an edge 204 of the first layer 210 of the leather interlayer 200. For related structural and connection relationships, refer to the embodiment shown in FIG. 1 to FIG. 4, and details are not described herein again.

As shown in FIG. 5 and FIG. 6, in this embodiment, a contour of an annular side wall formed by the retaining wall 110a matches the edge 204 of the first layer 210 of the leather interlayer 200, and the retaining wall 110a and the edge 204 of the first layer 210 come into close contact with each other. Moreover, a height Hn2 of the retaining wall 110a (that is, a depth of the recessed portion 130 in the normal direction Dn) and a height Hn1 of the first layer 210 are equal. In other words, the outer surface 104 of the plastic body 100a is coplanar with the first layer 210 of the leather interlayer 200 so as to have a visual effect of consistency in appearance. In different embodiments, the height of the retaining wall 110a may also be equal to an overall height of the leather interlayer 200, and the outer surface 104 of the plastic body 100a is coplanar with the second layer 220 of the leather interlayer 200.

As shown in FIG. 5 and FIG. 6, in this embodiment, an edge of a camera hole 120 has a metal sprayed layer 122. For example, the metal sprayed layer 122 is located on the outer surface 104, and the metal sprayed layer 122 surrounds and is adjacent to the camera hole 120. In this embodiment, the metal sprayed layer 122 protrudes from the outer surface 104. In addition to improving the aesthetic appearance, since the metal sprayed layer 122 is a protruded structure relative to the outer surface 104, the metal sprayed layer 122 can further ensure that the camera lens of the mobile phone 20 is not easily directly touched by an external object, thereby reducing an opportunity of causing the camera lens dirty or damaged.

In summary, the mobile phone housing according to the embodiments of the present invention, having a structural design based on the heterostructure of the plastic body and the leather interlayer that are joined through a single surface, not only improves the aesthetics but also reduces the manpower and time required for production and improves the yield, thereby reducing the production costs. In addition, the retaining wall can also serve as an alignment tool, making the plastic body and the leather interlayer be attached together more quickly and accurately during production. Moreover, through a design of the retaining wall, the edge of the leather interlayer may further be protected from being easily rubbed by the external object, such as the user's hand, the pocket or the bag. In this way, the problem is also resolved that an edge and a corner of the leather are prone to burrs or cracks due to frequent frictions after the conventional mobile phone housing has been used for a long time.

Although the technical content of the present invention has been disclosed above with reference to preferred embodiments, the embodiments are not intended to limit the present invention. Any variation and modification made by those skilled in the art without departing from the spirit of the present invention shall fall within the protection of the present invention. Therefore, the protection scope of the present invention is subject to the scope defined by the claims.

## Claims

1. A mobile phone housing (10, 10a), configured to contain a mobile phone (20), **characterized in that** the mobile phone housing (10, 10a) comprises:
a plastic body (100), comprising a mobile phone accommodating portion (102) configured to contain the mobile phone (20), an outer surface (104) and a retaining wall (110, 110a), wherein the outer surface (104) is disposed on an opposite side of the mobile phone accommodating portion (102), and the retaining wall (110, 110a) is located on the outer surface (104); and
a leather interlayer (200), comprising a card insertion portion (202), wherein the leather interlayer (200) is attached to the outer surface (104), and the retaining wall (110, 110a) surrounds the leather interlayer (200).

2. The mobile phone housing (10, 10a) according to claim 1, wherein the retaining wall (110, 110a) is adjacent to an edge (204) of the leather interlayer (200).

3. The mobile phone housing (10, 10a) according to claim 1, wherein the retaining wall (110, 110a) protrudes from the outer surface (104) to form an annular protrusion portion, and the leather interlayer (200) matches the protrusion portion.

4. The mobile phone housing (10, 10a) according to claim 1, wherein the retaining wall (110, 110a) is recessed in the outer surface (104) to form a recessed portion (130), and the leather interlayer (200) matches the recessed portion (130).

5. The mobile phone housing (10, 10a) according to claim 1, wherein the leather interlayer (200) further comprises a first layer (210) and a second layer (220), the first layer (210) is attached to the outer surface (104), the second layer (220) is attached to the first layer (210) and exposes a part of the first layer (210), and the first layer (210) and the second layer (220) form the card insertion portion (202).

6. The mobile phone housing (10, 10a) according to claim 5, wherein heights (Hn1, Hn2) of the retaining wall (110, 110a) and the first layer (210) are approximately equal in a normal direction of the outer surface (104).

7. The mobile phone housing (10, 10a) according to claim 5, wherein the leather interlayer (200) further comprises a magnetic isolation layer (230), and the magnetic isolation layer (230) is located in the card insertion portion (202).

8. The mobile phone housing (10, 10a) according to claim 7, wherein the magnetic isolation layer (230) comprises a polyethylene terephthalate layer and a graphene layer that are laminated.

9. The mobile phone housing (10, 10a) according to claim 5, wherein the first layer (210) is connected to three edges of the second layer (220).

10. The mobile phone housing (10, 10a) according to claim 9, wherein the first layer (210) and the second layer (220) are connected to each other through sewing or gluing.

11. The mobile phone housing (10, 10a) according to claim 1, wherein the plastic body (100) further comprises a camera hole (120), the camera hole (120) connects the accommodating portion and the outer surface (104), and an edge of the camera hole (120) has a metal sprayed layer (122).

12. The mobile phone housing (10, 10a) according to claim 1, further comprising a pad body (300), wherein the pad body (300) is located in the accommodating portion.

13. The mobile phone housing (10, 10a) according to claim 12, wherein the pad body (300) is a thin cloth pad.

14. The mobile phone housing (10, 10a) according to claim 13, wherein the thin cloth pad comprises microfiber cloth.

15. The mobile phone housing (10, 10a) according to claim 1, wherein the retaining wall (110, 110a) and the plastic body (100) are integrally formed.
